# EUROPEAN PATENT APPLICATION

(11) **EP 0 522 572 A1**
(43) Date of publication of application: **13.01.1993**
(21) Application number: 92111739.6
(22) Date of filing: 10.07.1992
(51) Int. Cl.: H01L 21/66, H01L 21/60, H01L 21/00

(54) **Method and device for measuring a semiconductor element with bumps, and method and device for manufacturing a semiconductor device**

(30) Priority: 12.07.1991 JP 172740/91
(71) Applicant: SUMITOMO ELECTRIC INDUSTRIES, LIMITED, Osaka 541 (JP)
(72) Inventor: Nishiguchi, Masanori, c/o Yokohama Works of, Sakae-ku, Yokohama-shi, Kanagawa (JP)
(74) Representative: Lehn, Werner, Dipl.-Ing.

(57) **Abstract**

A method for sufficiently measuring and evaluating the electrical characteristics of a semiconductor element (1) mounted using a flip-chip bonding method comprises the steps of preparing a measuring substrate for measuring the electrical characteristics of the semiconductor element; holding the semiconductor element (1) with the circuit surface facing the measuring substrate; positioning the bumps (b) with respect to the contact positions of the measuring substrate, where the bumps (b) of the semiconductor element (1) are connected; connecting the bumps (b) to the contact positions by way of anisotropic conductive member (4); and measuring the electrical characteristics of the semiconductor element (1) by energizing the measuring substrate.

## Description

### Background of the Invention

### (Field of the Invention)

The present invention relates to a method and device for measuring the electrical characteristics of a semiconductor element with bump electrodes, which is mounted on the circuit surface thereof and faces the wiring portion of the circuit board, and a method and device for manufacturing a semiconductor device having the semiconductor element.

### (Related Background Art)

With the increasing demand for large-scale function and high-speed operation of electronic devices, logic LSIs have achieved high-speed operation, with a delay time per gate of several hundreds of picoseconds. However, the conventional assembling structure which mounts a large number of dual-in packages (DIPs) or plug-in packages on a printed circuit board has become it difficult to sufficiently bring out performance of high-speed LSIs. To overcome such a problem, a multi-chip module system has been developed and put into practical use, which mounts a large number of chips on a single ceramic substrate and can provide high-speed performance with high density assembling (refer to "LSI HANDBOOK" the first edition, pp. 415-416, The Institute of Electronics and Communication Engineers of Japan, 1984). The flip-chip mounting method (or face-down bonding method) is well-known as a method for high-density assembling with the high-speed performance above mentioned.

When a defect is found in a mounted semiconductor element, the semiconductor element should be removed and then another semiconductor element is re-mounted, which is troublesome and substantially deteriorates workability. Therefore, before a semiconductor element is packaged on a circuit board, an evaluation is made regarding its expected performance. The semiconductor element is rejected if it does not satisfy its specification. The evaluation of electrical characteristics prior to the mounting has been performed by supplying a current needed for the measurement from a probe attached to a bump on a semiconductor element.

However, when the probe is attached directly to a bump on a semiconductor element prior to mounting, there are adverse effect to both the bump and the probe, thus lowering the final manufacturing yield and workability. Therefore, the inability to measure and evaluate the electrical characteristics sufficiently prior to mounting the semiconductor element was a problem.

### Summary of the Invention

An object of the present invention is to provide a method and a device for sufficiently measuring and evaluating the electrical characteristics of a semiconductor element mounted using a flip-chip bonding method.

To achieve above object, the measuring method according to the present invention comprises the steps of preparing a measuring substrate used for measuring the electrical characteristics of a semiconductor element; holding the semiconductor element with the circuit surface facing the measuring substrate; positioning bumps of the semiconductor element with respect to the contact positions of the measuring substrate where the bumps are connected; connecting the bumps to the contact positions by way of anisotropic conductive member; and measuring the electrical characteristics of the semiconductor element by energizing the measuring substrate.

A measuring device according to the present invention comprises a measuring substrate for measuring the electrical characteristics of a semiconductor element; a holding means for holding the semiconductor element while the circuit surface is positioned facing the measuring substrate; a positioning means for positioning the bumps with respect to the contact positions of the measuring substrate to which the bumps of the semiconductor element are connected; an anisotropic conductive member inserted between the semiconductor element and the measuring substrate; and a measuring means for measuring the electrical characteristics of the semiconductor element by energizing the measuring substrate.

Further, when a semiconductor element to be enclosed in a multi-chip module is measured, the substrate to be actually packaged may be arranged between an anisotropic conductive member and an measuring substrate, and then the bumps of the semiconductor element may be positioned with respect to the contact positions of the substrate.

In this case, a measuring device according to the present invention has a measuring substrate for measuring the electrical characteristics of a semiconductor element; holding means for holding the semiconductor element while the circuit surface is positioned facing a packaging substrate where only the semiconductor element to be connected to the packaging substrate is not mounted; a positioning means for positioning the bumps with respect to the contact positions of the measuring substrate to which the bumps of the semiconductor element are connected; an anisotropic conductive member between the semiconductor element and the packaging substrate; and a measuring means for measuring the electrical characteristics of the semiconductor element by energizing the measuring substrate.

According to the measuring method of the present invention, the electric resistance between the bumps of a semiconductor element and the contact positions of a measuring substrate is small, but the electric resistance is extremely large in the other directions. Therefore, as the bumps can be connected electrically to the contact positions, no electrical short-circuit occurs in the wiring circuit formed on the substrate.

According to the measuring device of the present invention, the bumps of a semiconductor element (a measuring substrate or a packaging substrate) are connected to the contact positions by way of an anisotropic conductive member, whereby the electrical characteristics when being actually packaged can be obtained without packaging a semiconductor element directly a substrate.

An another object of the present invention is to provide a device and a method for manufacturing a semiconductor device having above semiconductor element.

To achieve the object, the manufacturing device according to the present invention comprises a first holding means for holding the substrate, with the circuit portion thereof being placed upward, a first moving means for moving vertically the first holding means; a second holding means for holding the semiconductor element spaced from the substrate by a fixed distance while the circuit surface thereof faces outside; a second traveling means for travelling the second holding means in parallel with respect to the substrate; inserting means for inserting an anisotropic conductive member between the substrate and the semiconductor element; a probe to be connected to the substrate which is held on the first holding means; and a measuring means connected to the probe.

And the manufacturing method according to the present invention comprises the steps of a first step of holding the semiconductor element on the substrate so as to be spaced from the substrate by a fixed distance, while the circuit surface of the semiconductor element faces to the substrate; a second step of positioning the bumps of the semiconductor element with respect to the contact positions of the measuring substrate to which the bumps of the semiconductor element are connected; a third step of inserting the anisotropic conductive member between the bumps and the contact positions and connecting the bumps of the semiconductor element to the contact positions of the measuring substrate by way of the anisotropic conductive member; and a fourth step of measuring the electrical characteristics of the semiconductor element by energizing the measuring substrate and then fixing the above positioned semiconductor element on the substrate.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art form this detailed description.

### Brief Description of the Drawings

Fig. 1 is a perspective view showing the major portion of a semiconductor element measuring device according to the first embodiment of the present invention,
Fig. 2 is a vertical cross sectional view showing a semiconductor element measuring device according to the first embodiment of the present invention,
Fig. 3 is a flow diagram showing a semiconductor element measuring method according to the present invention,
Fig. 4 shows a perspective view showing the major portion of a measuring device applicable for a multi-chip module substrate to be packaged for a semiconductor element measuring device according to the second embodiment of the present invention,
Fig. 5 is a vertical cross sectional view showing a semiconductor element measuring device according to the second embodiment of the present invention,
Fig. 6A is a plan view showing a semiconductor device manufacturing device according to the present invention, and
Fig. 6B is a side view showing a semiconductor manufacturing device according to the present invention.

### Description of the Preferred Embodiment

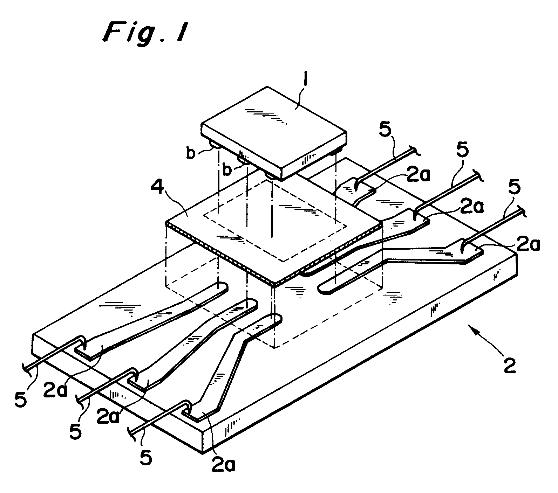

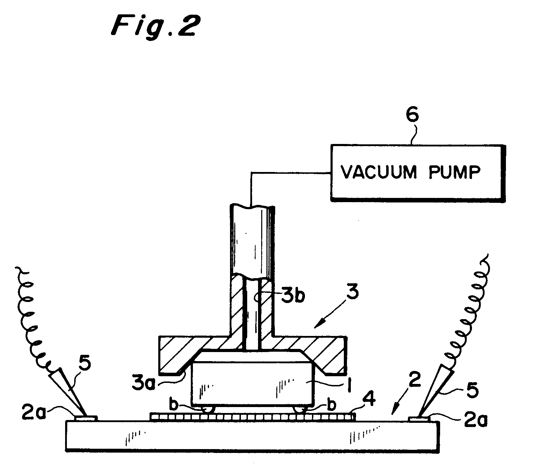

First, the device according to the present embodiment is explained in reference with Fig. 1 and Fig. 2. This device consists of an IC chip (semiconductor element) 1 where the bump "b" is formed on one surface thereof, an measuring substrate for measuring and evaluating the electrical characteristics of the IC chip 1, a collet (holding means) 3 for holding the IC chip 1, an anisotropic conductive film (anisotropic conductive member) 4 arranged between the IC chip 1 and the measuring substrate 2, and a probe 5 for energizing electrodes formed on the surface of the measuring substrate 2.

The IC chip 1 is a flip-chip type semiconductor chip mounted facing the circuit surface thereof at the wiring portion of the substrate. The bump electrodes "b" are formed on the circuit surface thereof. The test pattern used for measuring the electrical characteristics (functions, signal rise timing, signal fall timing, arithmetic operating speed, writing, reading time, etc.) of an IC chip 1 is formed on the upper surface of the measuring substrate 2. Contact portions to which the bump electrodes 2a of the IC chip are connected are formed on the wiring portion of the test pattern, and the electrodes 2a for supplying a current to the test pattern are formed on the peripheral portion of the test pattern. Since the collet 3 is mounted on the movable stage which can move in the direction of three axes intersecting perpendicularly to one another, the collet 3 can be moved at a desired position on the measuring substrate 2. Since this kind of the movable stage is well-known, its explanation is omitted. A pyramidal suction opening 3a is formed in the collet 3, arranged corresponding to an arranging position on a wiring substrate (not shown) and suitable for the shape of the IC chip 1. An exhaust vent 3b is connected to the vacuum pump 6 and is arranged to communicate with the suction opening 3a, whereby vacuum suction can be performed by the vacuum pump 6.

The anisotropic conductive film 4 is formed of a material with a high conductivity in a specified direction but an extreme small conductivity in the other direction. For example, a conductive macromolecular material (New Materials Manual, 1988 edition, pp. 937-939) can be used. Conductive macromolecular materials have electrical conductivity similar to those of metals such as copper, aluminum without impairing the superior properties (lightness, elasticity, flexibility, large area, processing characteristics, economic characteristics) of the macromolecular materials. For the anisotropic conductive film usable for the present embodiment, an insulating resin film can be used which is formed by burying densely minute conductive ball members (metal ball or the like) or conductive column members in the thickness direction so as not to contact them to each other. For example, a material called "Z-poxy" or "Z-poly" with a structure having metal ball buried therein and manufactured by A.I. Technology, Inc. (P.O.Box 3081, Princeton, NJ 08543, U.S.A.) can be used. The present embodiment employs a film with a high conductivity in the thickness direction thereof and is relatively soft. Therefore, it is easy to position the bump electrode b of the IC chip 1 to the contact portion of the measuring substrate 2, whereby damage to the bump electrodes "b" can be prevented.

The probe 5 can be finely adjusted laterally and longitudinally. The probe 5 is also connected to a high radio-frequency power supply and supplies the necessary current to measure the electrical characteristics of an IC chip 1.

Next, an explanation is given of an IC chip measuring method using the above measuring device in reference with Fig. 1, Fig. 2 and Fig. 3.

First, a semiconductor element or an IC chip 1 is held at the suction opening 3a of a collet 3 while the bump electrode "b" faces the wiring portion of the evaluating board 2 (step 101). Next, the collet 3 is moved with respect to the measuring substrate 2 with the space more than and equal to the film thickness of the anisotropic conductive film 4, to align the bump electrodes "b" of an IC chip 1 to the contact electrodes of the measuring substrate 2 (step 102). In the present embodiment, as a material with a high conductivity in the thickness direction is used as an anisotropic conductive film, the positioning process is completed by arranging the bump electrode "b" directly above the contact electrodes of the measuring substrate 2. The positioning process can be judged accurately by performing image processing using, for example, a TV camera or a computer together, and well-known techniques in the semiconductor fields can be applied. A concrete explanation will be made below regarding a method of positioning the contact portions of an measuring substrate 2. For example, assuming that X axis and Y axis are set so as to intersect perpendicularly to each other on the plan surface of the measuring substrate 2; a Z axis is set so as to intersect perpendicularly to both the X and Y axes; and the center coordinate of the contact portion of the measuring substrate 2 is (X₀,Y₀,Z₀) also, assuming that the conductive film 4 has a thickness t. The collet 3, which holds an IC chip 1, is moved at a position (X,Y,Z > Z₀+t) holding the gap between the bottom portion (bump electrode) and the measuring substrate 2 exceeds at least the thickness t. When a predetermined bump electrode on the IC chip 1 has reached the coordinate position (X₀,Y₀,Z) or positioned just over the contact portion of the measuring substrate 2, the collet 3 is ceased to move.

Next, the anisotropic conductive film 4 is inserted between the IC chip 1 and the measuring substrate 2. In this case, since the bottom portion of the IC chip 1 is sufficiently separated from the contact portions of the measuring substrate 2 by a distance allowing the insertion of conductive film 4, the conductive film 4 can be inserted simply between the IC chip 1 and the contact portions. And by lowering the collet 3 or lifting the measuring substrate 2 the bump electrodes "b" of the IC chip 1 are electrically connected to the contact portion of the measuring substrate 2 by way of the anisotropic film 4 (step 103, See Fig. 2). The conductive film 4 has a higher conductivity in the thickness direction. When the direction between the contact portion and the bump electrode is shifted slightly from the positioning direction, the conductivity between them decreases extremely. For that reason, the position shift can be recognized by detecting either the electrical conduction between the IC chip 1 and the contact portion or the normal operation of the IC chip 1. If an accurate positioning is not achieved, re-positioning is performed after lifting the collet 3 or descending the measuring substrate 2.

When resistors having a uniform resistivity are arranged around the contact portions of the IC chip 2, and one ends thereof are connected to the contact portions, the positional value shifted radially from the contact portions as a center can be measured. Furthermore, when resistors which have a resistance distribution indicating a specific resistance value depending on the position is arranged around the contact portions, both the positional shift and direction can be detected accurately. For example, when an elongated resistance material is arranged in a spiral form from the center of the contact portion, the amount of the resistance wire material, that is, radial positional shift and the angle from the contact portion can be calculated from the resistance value. Finally, the electrical characteristics of the IC chip 1 are measured by connecting the probe 5 to the electrodes 2a of the measuring substrate to supply a predetermined current (step 104).

According to the present invention, as the bump electrodes of the IC chip are connected to the electrodes 2a of the measuring substrate 2 with intervention of the anisotropic conductive film the situation of an IC chip which is actually mounted on a substrate can be simulated without damaging the bump electrodes of the IC chip, whereby the IC chip can be adequately measured and evaluated.

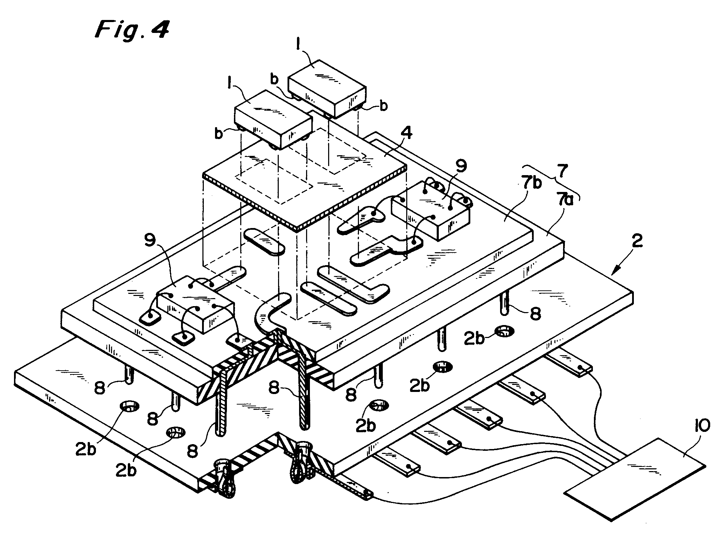

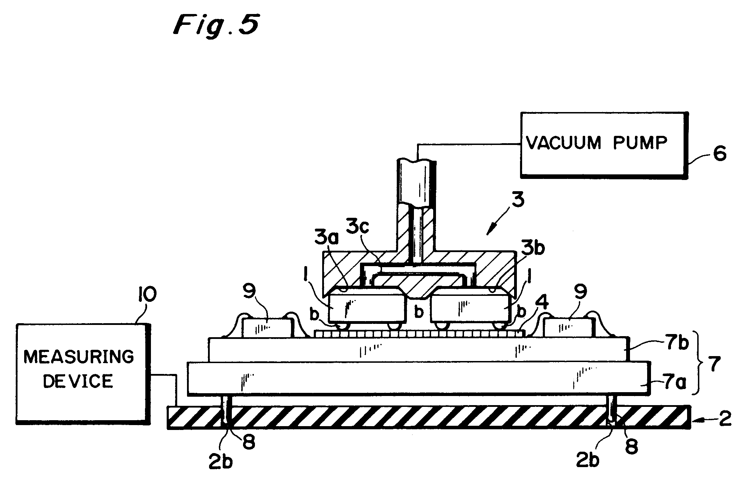

Next, referring to Figs. 4 and 5, an explanation is given of the semiconductor element measuring device according to a second embodiment of the present invention.

This device is different from the embodiment mentioned before in that prior to packaging a substrate structure with all electronic components except those to be mounted through the flip-chip method is used. The substrate structure 7 includes the lower substrate 7a and the upper substrate 7b.

The lower substrate 7a is formed of an alumina material (Al₂O₃), and has plural lead pins 8 extending from the bottom surface thereof, and is connected to electric circuits formed on the upper substrate 7b. The upper substrate 7b is formed of an insulating material with a low dielectric constant. For example, a polyimide multi-layered wiring structure having 3 inches square size, a thermal resistance of 3 °C/W with a thermal via, may be used (refer to "Copper Polyimide Multi-layered Wiring Boards" HYBRIDS, Vol. 7, No. 1, pp. 10-12). The upper substrate 7b has exposed electrodes on its surface while being mounted with IC chips 1 and 9 connected to the electrodes. The IC chip 9 is mounted on the upper substrate 7b by a wire-bonding process and is connected to the electrode formed on the surface of the upper substrate 7b. The lead pins 8 are inserted into the socket 2b formed in the measuring substrate 2 to supply the necessary current and to output measured values. Both the current supply and the measured value outputs are performed using the measuring apparatus 10 connected to the measuring substrate 2. The collet 3 is formed with plural suction openings 3a and 3b to hold plural IC chips simultaneously, the suction openings 3a and 3b being isolated from each other by the barrier 3c (refer to Japanese Patent Application Laid-open No. 246840-1988).

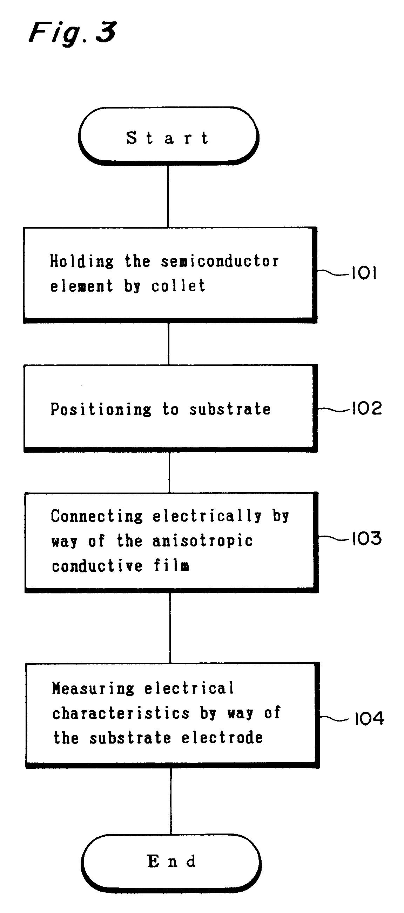

Next, referring to Fig. 3, Fig. 4 and Fig. 5, the IC chip measuring method using the measuring device above is explained below.

Two semiconductor elements or IC chips 1 are held simultaneously with the suction openings 3a and 3b of the collet 3 while the bump electrodes "b" face the wiring portion of the measuring substrate 2 (step 101). Next, the collet 3 is moved by being separated with a space from the substrate structure 7, corresponding to at least the film thickness of the anisotropic conductive film 4, and then the bump electrodes "b" of the IC chip 1 are aligned to the contact electrodes of the upper substrate 7b (step 102). Next, the anisotropic conductive film 4 is arranged between the IC chip 1 and the upper substrate 7b. Then, by lowering the collet 3 holding the IC chip 1, the bump electrodes "b" of the IC chip 1 are connected electrically to the contact portions of the upper substrate 7b through the anisotropic conductive film 4 (step 103). Finally, the electrical characteristics of the IC chip 1 are measured by supplying a predetermined current to the substrate structure 7 (step 104).

According to the present embodiment, because it is possible to produce the condition like that when the multi-chip module assembling is completed, the characteristics of a multi-chip module and the IC chips contained therein can be adequately evaluated.

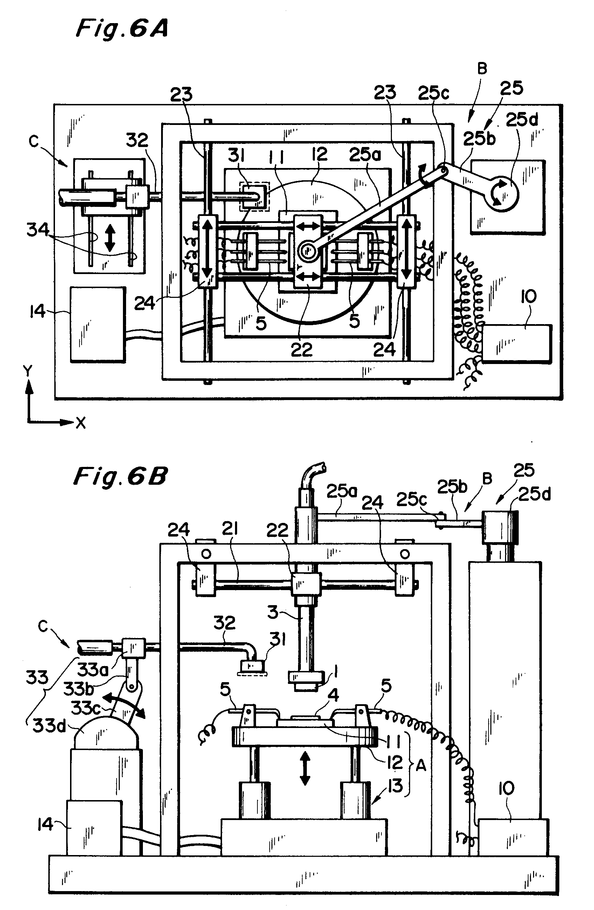

Next, referring to Figs. 6A and 6B, a semiconductor device manufacturing method and a semiconductor device manufacturing device according to the present invention will now be explained.

The manufacturing device comprises a substrate holding mechanism "A" for holding a substrate 1 on which a semiconductor element 1 with bumps are mounted, a collet moving mechanism "B" for moving horizontally the collet 3, and a film transferring mechanism "C" for transferring an anisotropic film 4.

In this case, the substrate holding mechanism "A" comprises a substrate 11 mounting a semiconductor element 1 with bumps, a holding member 12 for holding the substrate 11, and an elevating device for elevating the holding member 12. The elevating device 13 is connected to a compressor 14 for supplying compressed air, and has such a structure that the holding member 12 is driven by a compressed air.The collet moving mechanism "B" comprises a first guiding means 21 for extending in the X direction, a first traveling member 22 for traveling freely along the first guiding member 21, a second guiding member 23 for extending in the Y direction, a second traveling member 24 fixed to both ends of the first guiding member 21 for traveling freely along the second guiding member 23, and a driving means connected to the first traveling means 22 for enabling the first traveling means 22 to move two-dimensionally. The driving device 25 is constructed of two arms 25a and 25b as well as rotary portions 25c and 25d. The rotary portion 25c is arranged between the two arms 25a and 25b so as to set freely a rotational angle of the rotary portion 25a with respect to the arm 25b. The rotary portion 25d is arranged to the mounting portion of the arm 25b so as to set freely a rotational angle of the arm 25b. Therefore, the first traveling member 22 can be traveled to a given position by controlling the rotary portions 25c and 25d.

The film transferring mechanism "C" comprises a suction portion 31 for sucking an anisotropic conductive member 4, an arm portion 32, and a transferring portion 33, and can travel along the guiding groove 34 in the Y direction. The transferring portion 33 includes a moving member 33a, a first arm portion 33b, a second arm portion 33c, and a driving portion 33d. The suction portion 31 approaches to the substrate 10 through the rotation of the driving portion 33d.

Next, an explanation will be made below as for the manufacturing method of a semiconductor device using the above mentioned manufacturing device.

First, the substrate 11 is fixed on the holding member 12. In this case, the probes 5 are connected to the electrodes of the substrate 11. Next, the collet 3 is kept away from the center portion by driving the collet traveling mechanism "B", and in turn the film transferring mechanism "C" is moved toward the center portion. Then an anisotropic conductive member 4 is mounted on the substrate 11 by driving the film transferring mechanism "C". Since the position of the substrate 11 is fixed previously, the film transferring mechanism "C" can convey automatically to the substrate 11 by rotating the second arm portion 33c at the terminated portion. Thereafter, the film transferring mechanism "C" and the collet 3 are restored to their original positions respectively (refer to Fig. 6A), and then the collet 3 which has sucked an IC chip 1 is moved just over the substrate 11 (refer to Fig. 6B). Finally, the holding member 12 is lifted by driving the elevating device 13 and then the anisotropic conductive member 4 is contacted to the IC chip 1. The completeness of the positioning of the IC chip 1 can be judged whether the IC chip can perform its predetermined operation by conducting current to the IC chip 1 through the probes 5.

After the IC chip 1 is positioned accurately, the semiconductor device is completed by fixing the substrate 11, the anisotropic conductive member 4, and the IC chip 1. When the positioning is unsatisfactory, the positioning process is performed again by re-lifting the collet 3. Since the bump electrodes which are formed on the back surfaces of the IC chip 1 do not touch directly to the electrodes formed on the substrate 11, the bumps are not damaged accidentally.

Incidentally, the present invention should not be restricted to the above-mentioned embodiment. For example, when the semiconductor element is a high-speed GaAs IC, or similar device, a microwave prober may be used.

A flat collet may be used as the holding means, instead of the pyramid-type collet.

Because the present invention has the above-mentioned structure, it is possible to apply for measuring and evaluating a semiconductor chip mounted in multi-chip modules and single-chip modules, allowing adequate measurement and evaluation of semiconductor chips.

Because only semiconductor chips with normal electrical characteristics are mounted, the frequency of repairs on the semiconductor element mounted using flip-chip process can be reduced. As a result, low cost and high manufacturing yield can be achieved.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. A method of measuring electrical characteristics of a semiconductor element with bumps to be mounted on a substrate having a wiring portion thereon, with the circuit surface thereof facing said substrate, comprising:
a first step of preparing a measuring substrate for measuring electrical characteristics of said semiconductor element, and an anisotropic conductive member;
a second step of holding said semiconductor substrate so as to be spaced from said measuring substrate while the circuit surface thereof faces to said measuring substrate;
a third step of positioning the bumps of said semiconductor substrate with respect to contact positions of said measuring substrate to be connected to said bumps of said semiconductor element;
a fourth step of inserting said anisotropic conductive member between said bumps and said contact positions, and then connecting the bumps of said semiconductor element to said contact positions of said measuring substrate by way of said anisotropic conductive member; and
a fifth step of energizing said measuring substrate to measure the electrical characteristics of said semiconductor element.

2. A method of measuring electrical characteristics of a semiconductor element with bumps to be mounted on a substrate having a wiring portion thereon, with the circuit surface thereof facing to said substrate, comprising:
a first step of preparing a measuring substrate for measuring electrical characteristics of said semiconductor element, a packaging substrate prior to packaging which does not have said semiconductor element mounted thereon and is connected to said measuring substrate, and an anisotropic conductive member;
a second step of holding said semiconductor element spaced from said packaging substrate by a predetermined distance while said circuit surface thereof faces to said packaging substrate; a third step of positioning the bumps with respect to said contact positions to which said bumps of said semiconductor element are to be connected;
a fourth step of inserting said anisotropic conductive member between said bumps and said contact positions, and then connecting said bumps of said semiconductor element to said contact positions of said packaging substrate by way of said anisotropic conductive member; and
a fifth step of energizing said measuring substrate to measure the electrical characteristics of said semiconductor element.

3. A method of measuring a semiconductor element with bumps according to claim 1 or 2, wherein said semiconductor element is held so as to be spaced by a distance being more than the thickness of said anisotropic conductive member in said second step.

4. A method of measuring a semiconductor element with bumps according to claim 1 or 2, wherein said semiconductor element is held by means of a collet connected to a vacuum pump in said second step.

5. A device for measuring electrical characteristics of a semiconductor element with bumps to be mounted on a substrate having a wiring portion thereon, with the circuit surface thereof facing to said substrate, comprising:
a measuring substrate having contact positions corresponding to said bumps for measuring electrical characteristics of said semiconductor element;
holding means for holding said semiconductor element while said circuit surface thereof faces to said measuring substrate;
positioning means of positioning the bumps with respect to said contact positions;
an anisotropic conductive member inserted between said semiconductor element and said measuring substrate; and
a measuring substrate for measuring the electrical characteristics of said semiconductor element by energizing said measuring substrate.

6. A device for measuring electrical characteristics of a semiconductor element with bumps to be mounted on a substrate having a wiring portion thereon, with the circuit surface thereof facing to said substrate, comprising:
a measuring substrate for measuring the electrical characteristics of said semiconductor element;
holding means for holding said semiconductor element while the circuit surface thereof faces to said packaging substrate, said packaging substrate having contact positions corresponding to said bumps and connected to said measuring substrate, said packaging substrate prior to packaging which does not mount said semiconductor element;
positioning means for positioning said bumps with respect to said contact positions;
anisotropic conductive means inserted between said semiconductor element and said packaging substrate; and;
measuring means for measuring the electrical characteristics of said semiconductor element by energizing said measuring substrate.

7. A device for measuring a semiconductor element with bumps according to claim 5 or 6, wherein said anisotropic conductive member includes a conductive film in a plate form having a flexibility which does not damage the bumps of said semiconductor element.

8. A device for measuring a semiconductor element with bumps according to claim 7, wherein said conductive film has a high conductivity in the thickness direction and a low conductivity in the other directions.

9. A device for measuring a semiconductor element with bumps according to claim 14, wherein said conductive film has an area which covers at least all said bumps of said semiconductor element.

10. A device for measuring a semiconductor element with bumps according to claim 5 or 6, wherein said holding means includes a collet connected to a vacuum pump for holding said semiconductor element while the said bumps face outside, said collet having a suction opening coincident with the shape of said semiconductor element.

11. A device for measuring a semiconductor element with bumps according to claim 10, wherein said collet has a plurality of said suction openings.

12. A device for manufacturing a semiconductor element with bumps on a substrate having a wiring portion thereon with the circuit surface thereof facing to said substrate, comprising:
a first holding means for holding said substrate, with the circuit portion thereof being placed upward,
a first moving means for moving vertically said first holding means;
a second holding means for holding said semiconductor element spaced from said substrate by a fixed distance while the circuit surface thereof faces outside;
a second moving means for moving said second holding means in parallel with respect to said substrate;
inserting means for inserting an anisotropic conductive member between said substrate and said semiconductor element;
a probe to be connected to said substrate which is held on said first holding means; and
a measuring means connected to said probe.

13. A device for manufacturing and/or measuring a semiconductor element with bumps according to claim 18, wherein said anisotropic conductive member includes a conductive film in a plate form having a flexibility which does not damage the bumps of said semiconductor element, said conductive film having a high conductivity in the thickness direction and a low conductivity in the other directions.

14. A method for manufacturing a semiconductor device in which a semiconductor element is mounted on a substrate using an anisotropic conductive film while the circuit surface thereof faces to said substrate, said substrate having a wiring portion thereon, comprising:
a first step of holding said semiconductor element on said substrate so as to be spaced from said substrate by a fixed distance, while the circuit surface of said semiconductor element faces to said substrate;
a second step of positioning the bumps of said semiconductor element with respect to the contact positions of said measuring substrate to which the bumps of said semiconductor element are connected;
a third step of inserting said anisotropic conductive member between said bumps and said contact positions and connecting the bumps of said semiconductor element to said contact positions of said measuring substrate by way of said anisotropic conductive member; and
a fourth step of measuring the electrical characteristics of said semiconductor element by energizing said measuring substrate and then fixing the above positioned semiconductor element on said substrate.

15. A method for manufacturing and/or measuring a semiconductor element with bumps according to claim 9, wherein said semiconductor element is held so as to be spaced by a distance being more than the thickness of said anisotropic conductive member in the second step.
